(19) Europäisches Patentamt
European Patent Office
Office européen des brevets

(11) Veröffentlichungsnummer: **0 325 774 B1**

(12) **EUROPÄISCHE PATENTSCHRIFT**

(45) Veröffentlichungstag der Patentschrift: **18.03.92**

(51) Int. Cl.$^5$: **H01L 29/74**, H01L 23/48

(21) Anmeldenummer: **88121452.2**

(22) Anmeldetag: **22.12.88**

# (54) Abschaltbares Leistungshalbleiterbauelement.

(30) Priorität: **27.01.88 CH 275/88**

(43) Veröffentlichungstag der Anmeldung:
**02.08.89 Patentblatt 89/31**

(45) Bekanntmachung des Hinweises auf die Patenterteilung:
**18.03.92 Patentblatt 92/12**

(84) Benannte Vertragsstaaten:
**BE CH DE FR GB IT LI NL SE**

(56) Entgegenhaltungen:
**EP-A- 0 064 231** **EP-A- 0 200 863**
**DE-A- 2 719 219** **FR-A- 2 207 358**
**FR-A- 2 393 433** **US-A- 4 402 004**

(73) Patentinhaber: **ASEA BROWN BOVERI AG**
**Haselstrasse**
**CH-5401 Baden(CH)**

(72) Erfinder: **Jaecklin, André, Dr.**
**Geissbergstrasse 55**
**CH-5400 Ennetbaden(CH)**
Erfinder: **Zimmermann, Wolfgang, Dr.**
**Rottrottenstrasse 24**
**CH-5313 Klingnau(CH)**

**EP 0 325 774 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung bezieht sich auf das Gebiet der Leistungshalbleiter. Sie betrifft insbesondere ein abschaltbares Halbleiterbauelement, umfassend

- eine Halbleiterscheibe;
- in einem ersten Bereich der Halbleiterscheibe eine erste Folge von unterschiedlich dotierten Schichten, die zwischen einer Kathodenseite und einer Anodenseite angeordnet sind, und einen über ein Gate abschaltbaren Thyristor (GTO) bilden;
- in dem ersten Bereich zumindest kathodenseitig eine stufenförmige Gate-Kathoden-Struktur mit einer Mehrzahl von erhabenen Kathodenfingern, welche von einem tieferliegenden Gatebereich umgeben sind;
- in dem ersten Bereich auf den Kathodenfingern jeweils eine metallische Kathodenschicht, und anodenseitig auf der Halbleiterscheibe eine metallische Anodenschicht;
- in einem zweiten Bereich der Halbleiterscheibe eine zweite Folge von unterschiedlich dotierten Schichten, die zwischen der Kathodenseite und der Anodenseite angeordnet sind, und ein zum GTO-Thyristor parallelgeschaltetes Bauelement bilden;
- in dem zweiten Bereich entsprechende metallische Schichten, die zur Kontaktierung anodenseitig und kathodenseitig auf die Halbleiterscheibe aufgebracht sind; und
- eine kathodenseitige Druckkontaktscheibe, welche zur Kontaktierung auf die Kathodenschicht und die entsprechende Schicht im zweiten Bereich gepresst wird.

Ein solches Bauelement ist z.B. aus der EP-A1 0 200 863 bekannt.

Die zunehmende Verbreitung der Leistungselektronik in der Energieübertragung und -steuerung oder in elektrischen Antrieben hat zu der Entwicklung von immer leistungsfähigeren Leistungshalbleitern, insbesondere Dioden und Thyristoren, geführt, die mit immer grösseren Durchmessern der Halbleiterscheiben eine steigende Stromtragfähigkeit und steigende Sperrspannungen aufweisen. Die Probleme bei der Herstellung solcher hochbelastbarer Leistungshalbleiter liegen nicht allein in der Präparation der Halbleiterscheibe selber, sondern vor allem auch beim Einbau der Scheibe in ein geeignetes Gehäuse.

Bei diesem Einbau muss nicht nur auf guten elektrischen und thermischen Kontakt zwischen Halbleiterscheibe und Umgebung geachtet werden, sondern auch auf eine ausreichende Lastwechselfestigkeit, d.h. auf einen ausreichenden Schutz des eingebauten Elements gegen Ermüdung bei wechselnder Belastung. Besondere Bedeutung kommt hierbei der Kontaktierung der Halbleiterscheibe innerhalb des Gehäuses zu.

Es ist nun seit langem bekannt, für Leistungshalbleiter den sogenannten "legierten Druckkontakt" zu verwenden (siehe z.B. J.Knobloch, S.Prough, "Solderless Construction of large Diameter Silicon Power Devices", Proc. IAS Conf. 1977), bei dem die Halbleiterscheibe einseitig mittels eines speziellen Lotes (z.B. einer Aluminium-Legierung) auf eine Metallunterlage (z.B. aus Mo oder W) gelötet und von der anderen Seite mit einer aufgepressten Metallscheibe druckkontaktiert wird.

Die durch das Löten erzeugte Halbleiter-Metall-Schichtstruktur führt wegen der nicht vernachlässigbaren Unterschiede in den thermischen Ausdehnungskoeffizienten bei den wachsenden Durchmessern der Halbleiterscheiben zu grösser werdenden mechanischen Biegespannungen, welche die Lastwechselfestigkeit des Bauelements nachhaltig verschlechtern. Insbesondere führt die Aufwölbung der Halbleiterscheibe bei den nach dem Lötprozess notwendigen fotolithografischen Schritten zu einer unbefriedigenden optischen Auflösung. Ausserdem wächst die Gefahr von Lunkern im Randgebiet bei grossen Durchmessern.

Man ist daher dazu übergegangen, bei herkömmlichen Thyristoren und Dioden den legierten Druckkontakt durch den sogenannten "direkten Druckkontakt" zu ersetzen, bei dem die Halbleiterscheibe von beiden Seiten durch angepresste Metallscheiben druckkontaktiert wird (siehe z.B. den o.g. Artikel von J.Knoblauch et al. oder Brown Boveri Mitt. 1 (1979), S. 5-10).

Diese Art der Kontaktierung hat sich bei herkömmlichen Thyristoren, die eine Halbleiterscheibe mit beidseitig planaren Oberflächen aufweisen, bewährt, da hier wegen der Planarität eine ausreichend homogene Druckverteilung innerhalb der Halbleiterscheibe gewährleistet ist.

Anders ist die Situation jedoch bei den abschaltbaren GTO (Gate Turn Off)-Thyristoren mit stufenartiger Gate-Kathodenstruktur (siehe z.B. US-PS 4 127 863), bei denen auf der Kathodenseite für die Druckkontaktierung nur noch die Mehrzahl der erhabenen Kathodenfinger zur Verfügung steht, die mit ihrer insgesamt kleineren Fläche einen höheren Druck aufnehmen und möglichst gleichmässig in das Volumen der Halbleiterscheibe einleiten müssen.

In der DE-OS 27 19 219 (Fig. 6F und zugehörige Beschreibung) ist nun prinzipiell vorgeschlagen worden, den direkten Druckkontakt auch bei einem solchen GTO-Thyristor zu verwenden. Dieser Vorschlag geht jedoch über das Prinzipielle nicht hinaus und umfasst insbesondere keinerlei Angaben, die eine Realisierung des direkten Druckkontakts unter den beim GTO vorliegenden schwierigen Bedingungen

gestatten.

Dass die Bedingungen bei einem GTO mit stufenförmiger Gate-Kathoden-Struktur tatsächlich schwierig sind, lässt sich aus der DE-OS 31 34 074 (S. 20, Zeilen 2-21) entnehmen, wo selbst bei dem dort verwendeten, einfacheren, legierten Druckkontakt die Gatebereiche auf die Höhe der Kathodenfinger gebracht worden sind, um eine Druckentlastung der Kathodenfinger zu erreichen.

Die technologischen Schwierigkeiten mit einem direkten Druckkontakt bei den beschriebenen GTO-Thyristoren haben dazu geführt dass die bisher kommerziell erhältlichen Hochleistungs-GTOs ausschliesslich mit einem legierten Druckkontakt ausgestattet sind (siehe z.B. IEEE Transactions On Electron Devices, Vol. ED-28, No. 3, März 1981, S. 270-274).

Zur Lösung der erwähnten technologischen Schwierigkeiten ist in der älteren Europäischen Patentanmeldung EP-A-0 254 910 (entsprechend der US-Anmeldung, Serial No. 07/071 399) ein GTO-Thyristor mit direktem Druckkontakt vorgeschlagen worden, bei dem stabile Kontaktverhältnisse durch vorgegebene Toleranzen für die Druckflächen und die geometrische Anordnung der Druckkontakte erreicht werden.

Der bisher angeführte Stand der Technik bezieht sich auf die Druckkontaktierung von einzelnen GTO-Elementen, bei denen auf der Kathodenseite bzw. Anodenseite im wesentlichen einheitliche Verhältnisse bezüglich der Druckflächenverteilung anzutreffen sind.

Es gibt nun aber neben den einzelnen GTO-Bauelementen auch kombinierte abschaltbare Bauelemente (z.B. den rückwärtsleitenden GTO-Thyristor der eingangs genannten EP-A1 0 200 863 mit seiner Anti-Parallelschaltung von GTO-Thyristor und Diode), bei denen in einer Halbleiterscheibe nebeneinander in mehreren Bereichen unterschiedliche Bauelemente, integriert sind, die aber auf der Anoden- bzw. Kathodenseite gemeinsam kontaktiert werden.

Bei solchen kombinierten Bauelementen mit wenigstens einem GTO-Thyristor mit stufenförmiger Gate-Kathoden-Struktur treten wegen dieser Struktur zunächst einmal dieselben technologischen Schwierigkeiten mit einem direkten Druckkontakt auf, wie sie bei GTO-Einzelelement beschrieben worden sind.

Darüber hinaus ist hier jedoch auch noch eine ungleiche Verteilung der Druckflächen zu berücksichtigen (im Fall des erwähnten rückwärtsleitenden GTO-Thyristors drückt die kathodenseitige Druckkontaktscheibe einerseits auf die fein verteilten kleinen Flächen der Kathodenfinger vom GTO-Thyristor, andererseits auf den vergleichsweise grossen Kontaktbereich der integrierten Diode).

Aufgabe der vorliegenden Erfindung ist es nun, ein abschaltbares Halbleiterbauelement zu schaffen, bei dem ein GTO-Thyristor mit wenigstens einem weiteren Bauelement in einer gemeinsamen Halbleiterscheibe integriert ist, und das mit einem direkten Druckkontakt ausgerüstet ist und eine ausreichende Lastwechselfestigkeit aufweist.

Die Aufgabe wird bei einem Halbleiterbauelement der eingangs genannten Art dadurch gelöst, dass

- eine anodenseitige Druckkontaktscheibe vorgesehen ist, welche zur Kontaktierung auf die Anodenschicht und die entsprechende Schicht im zweiten Bereich gepresst wird;
- die Druckkontaktscheiben und die Halbleiterscheibe auf ihren druckbelasteten Kontaktflächen eine Planitätsabweichung von weniger als ±5 Mikrometer aufweisen; und
- die Druckkontaktscheiben gegeneinander so ausgerichtet sind, dass die Abweichung ihrer Mittelachsen voneinander weniger als 500 Mikrometer beträgt.

Durch das Zusammenwirken dieser Massnahmen wird wirkungsvoll verhindert, dass die am Bauelement auftretenden Lastwechsel über entsprechende mechanische Spannungen die Funktionsfähigkeit des Bauelements beeinträchtigen.

In einer ersten bevorzugten Ausführungsform der Erfindung ist das Bauelement im zweiten Bereich der Halbleiterscheibe eine Diode, die zusammen mit dem GTO-Thyristor des ersten Bereichs einen rückwärtsleitenden GTO-Thyristor bildet.

In einer zweiten bevorzugten Ausführungsform der Erfindung ist das Bauelement im zweiten Bereich der Halbleiterscheibe ebenfalls ein GTO-Thyristor mit entsprechender stufenförmiger Gate-Kathoden-Struktur und entsprechenden Kathodenfingern, wobei beide GTO-Thyristoren antiparallel angeordnet sind.

Die Druckkontaktscheiben des erfindungsgemässen Bauelements bestehen vorzugsweise aus Molybdän oder Wolfram.

Besonders gute Ergebnisse lassen sich erzielen, wenn die Planitätsabweichungen weniger als ± 1 µm und die Abweichung der Mittelachsen weniger als 100 µm betragen.

Da die Vorteile der Druckkontaktierung mit zunehmendem Durchmesser stärker ins Gewicht fallen (Durchbiegung, Lunkerproblem), ist es günstig, diesen für Durchmesser grösser als 20 mm anzuwenden.

Weitere Ausführungsbeispiele der Erfindung ergeben sich aus den Unteransprüchen.

Die Erfindung soll nachfolgend anhand von Ausführungsbeispielen im Zusammenhang mit der Zeichnung näher erläutert werden. Es zeigen:

Fig. 1 einen direkten Druckkontakt für ein GTO-Einzelelement gemäss der älteren Europäischen

Anmeldung EP-A-0 254 910;

Fig. 2 einen direkten Druckkontakt für ein kombiniertes abschaltbares Bauelement gemäss einem ersten Ausführungsbeispiel der Erfindung;

Fig. 3A, B verschiedene Anordnungen der Bauelement-Bereiche bei einem Bauelement gemäss Fig. 2; und

Fig. 4 einen direkten Druckkontakt für ein kombiniertes abschaltbares Bauelement gemäss einem zweiten Ausführungsbeispiel der Erfindung.

Wie bereits erwähnt, hat sich in der Praxis die Verwendung des direkten Druckkontaktes bisher auf Leistungshalbleiter, insbesondere Dioden und Transistoren, mit grossflächigen Kathoden beschränkt, bei denen die angepasste metallische Druckkontakt-Scheibe aus W oder Mo im wesentlichen gleich gross war wie die Kathodenfläche.

Wichtigstes Merkmal war dabei eine einfach zusammenhängende Fläche der Kathode. Im Extremfall waren höchstens einzelne Gräben vorgesehen (z.B. beim sogenannten "Fingergate"), die jedoch nur einen geringen Teil der Kathodenfläche einnahmen. Ueber den Hauptteil der Fläche waren deshalb homogene Druckverhältnisse gewährleistet, so dass allenfalls in den Randbereichen mit geringen, lokalen Drucküberhöhungen gerechnet werden musste.

Beim GTO-Thyristor weist die Halbleiterscheibe nun kathodenseitig eine Vielzahl von länglichen, inselförmigen Kathodenfingern auf, die meist in einer Rosettenstruktur (siehe z.B. Fig. 3 der DE-OS 31 34 074) angeordnet sind. Die anodenseitige Kontaktfläche ist im einfachsten Fall nicht unterteilt, kann aber auch eine Stufenstruktur z.B. in Form verteilter Anodenshorts oder anodenseitiger, tieferliegender Gatebereiche aufweisen.

Ein solcher Thyristor mit planarer Anodenfläche ist in der Fig. 1 dargestellt. Zentrales Element der Anordnung ist eine Halbleiterscheibe 2 mit einer Folge von unterschiedlich dotierten Schichten, deren Grenzen in der Figur gestrichelt angedeutet sind.

Kathodenseitig (in der Fig. 1 oben) weist die Halbleiterscheibe eine stufenförmige Gate-Kathoden-Struktur auf, in der eine Vielzahl von erhabenen Kathodenfingern 7 von einem tieferliegenden Gatebereich umgeben sind.

Die Kathodenfinger 7 sind mit einer metallischen Kathodenschicht 6, z.B. aus Al, belegt. Auch der dazwischen liegende Gatebereich ist mit einer metallischen Gateelektrode 5 versehen, die entsprechend tiefer liegt als die Kathodenschicht 6.

Anodenseitig (in der Fig. 1 unten) ist die Halbleiterscheibe 2 im einfachsten Fall nahezu ganzflächig mit einer Anodenschicht 4, ebenfalls aus Al, belegt. Am Rande ist die Halbleiterscheibe 2 in üblicher Weise angeschrägt und mit einer Randpassivierung 9 versehen. Die Gateelektrode 5, die im dargestellten Beispiel nicht druckkontaktiert wird, ist zum Schutz mit einer Isolationsschicht 8, z.B. einem Polyimid, überdeckt.

Der direkte Druckkontakt umfasst eine kathodenseitige Druckkontaktscheibe 1 und eine anodenseitige Druckkontaktscheibe 3, die vorzugsweise aus Mo- oder W-Blech hergestellt sind. Beide Druckkontaktscheiben 1, 3 werden von beiden Seiten mit einem ausreichenden Anpressdruck P gegen die Halbleiterscheibe 2 gepresst, um den elektrischen und thermischen Kontakt innerhalb des Bauelements zu gewährleisten.

Mit den Kathodenfingern 7 in Rosettenstruktur ergibt sich ein typisches Verhältnis von Anodenfläche $A_A$ zu Kathodenfläche $A_K$ von

$$2 < \frac{A_A}{A_K} < 5$$

Um einen akzeptablen Wärmeübergang sicherzustellen, muss der Druck in der Anodenfläche den bei derartigen Bauelementen üblichen Werten von typischerweise 10 ... 15 MPa entsprechen. Für den Druck auf der Kathodenseite ergibt sich ein entsprechend dem Verhältnis $A_A/A_K$ erhöhter Wert.

Zusätzlich zu dem durch das ungünstige Flächenverhältnis erhöhten Druck muss mit weiteren lokalen Drucküberhöhungen gerechnet werden, nämlich

(a) mit einer ausgeprägten Drucküberhöhung in der Nähe des Druckkontakt-Randes (sog. Stempel-Effekt), und

(b) mit einer Drucküberhöhung im Bereich der Kerben in der Halbleiterscheibe.

Diese mechanische Beanspruchungen lassen sich für eine vorgegebene Geometrie numerisch berechnen (vgl. z.B. A.C. Zinkiewicz, Y.K. Cheung, "The finite element method in structural and continuum mechanics," Mc Graw-Hill, 1970).

In der Praxis bewirkt die Drucküberhöhung (a) zum Beispiel, dass die Fliessgrenze am Rande der Kathoden- bzw. Anodenschicht 6 bzw. 4 zuerst erreicht wird. Ein derartiges, geringfügiges Fliessen hat jedoch automatisch einen Ausgleich der Drucküberhöhung zur Folge. Drucktechnisch ist daher dieser Fall in der Regel unkritisch, solange sich dadurch die Fläche des metallisierten Bereiches nur unwesentlich vergrössert.

Eine Drucküberhöhung vom Typ (b) führt zu einer Kerbwirkung. Die theoretische Berechnung eines typischen Anwendungsfalles zeigt, dass die lokale mechanische Spannung in der Halbleiterscheibe 2 um einen Faktor grösser als 2 steigt. Diese Zusatzbeanspruchung ist besonders kritisch, da sich hierzu noch die durch thermische Ausdehnung der verschiedenen Materialien induzierten Zug- bzw. Scherspannungen überlagern. Falls die Dicke der mechanisch gepressten Scheibe viel grösser ist, als die laterale Ausdehnung der nicht gepressten Bereiche (im Falle des GTO der Lücken zwischen den Kathodenfingern 7), gleichen sich die Spannungen innerhalb der Scheibe mit zunehmender Distanz von der Kathodenoberfläche vollständig aus. Dieser Effekt ist als Prinzip von de Saint-Venant bekannt (vgl. z.B. I. Szabo, "Einführung in die technische Mechanik", 7. Auflage, Springer-Verlag 1966, S. 130). Er ist beim legierten Druckkontakt wirksam, weil Halbleiterscheibe und angelötete Unterlage eine einheitliche Scheibe grösserer Dicke bilden.

Beim direkten Druckkontakt, wo die gepresste Halbleiterscheibe nicht legiert ist, ist obige Bedingung nicht erfüllt. Die mechanischen Spannungen sind in der ganzen Halbleiterscheibe inhomogen und können lokal sogar das Vorzeichen wechseln (sog. Filon-Effekt, d.h. örtliches Abheben der gepressten Scheibe auf der ebenen Rückseite). Aus diesem Grunde musste davon ausgegangen werden, dass der direkte Druckkontakt bei der beschriebenen Inselstruktur zur Zerstörung der Halbleiterscheibe führt.

In einer Versuchsreihe, die an GTO-Thyristoren mit direktem Druckkontakt unter extremen Druck- und Temperaturbelastungen durchgeführt worden ist, hat sich nun überraschenderweise herausgestellt, dass der direkte Druckkontakt bei GTOs mit strukturierter Kathodenoberfläche praktikabel ist, wenn bestimmte Massnahmen ergriffen werden.

Wichtig ist dabei zunächst die Planität, d.h. Ebenheit der Flächen von Halbleiterscheibe und Druckkontakten, die miteinander in Kontakt stehen. Die Unebenheiten dieser Flächen, die Planitätsabweichung darf nicht mehr als 5 $\mu$m betragen und sollte vorzugsweise unterhalb von 1 $\mu$m liegen.

Weiterhin müssen an den Druckkontaktscheiben 1 und 3 scharfe Kanten vermieden werden, die, wenn der Druckkontakt innerhalb der Fläche der Halbleiterscheibe endet, zu den bereits beschriebenen Fliessvorgängen führen.

Für den einfachsten Fall einer planaren Anodenseite (siehe die Fig. 1) muss zumindest die anodenseitige Druckkontaktscheibe 3 auf der der Halbleiterscheibe 2 zugewandten Seite an ihrer Kante facettiert oder abgerundet sein.

Schliesslich müssen die äusseren Begrenzungen der gegenüberliegenden Druckkontaktscheiben 1 und 3 innerhalb enger Toleranzen ausgerichtet sein. Ausreichend ist hier, dass die Druckkontaktscheiben 1 und 3 in ihren Mittelachsen um weniger als 500 $\mu$m voneinander abweichen, was bei gleichem Durchmesser einer gleich grossen Radiusdifferenz $\Delta r$ (eingezeichnet in der Figur) entspricht.

Bevorzugt ist auch der Durchmesser der kathodenseitigen Druckkontaktscheibe 1 so gewählt, dass sein Rand über die Kathodenfinger 7 seitlich hinausragt. Es ist jedoch auch möglich (in der Figur gestrichelt eingezeichnet) für beide Druckkontaktscheiben 1, 3 geringere Durchmesser zu wählen.

Im einzelnen werden bei der Anordnung die folgenden Abmessungen bevorzugt:

| | |
|---|---|
| Durchmesser der Druckkontaktscheiben | > 20 mm |
| Breite der Kathodenfinger | > 0,1 mm |
| Länge der Kathodenfinger | > 1 mm |
| Grabentiefe zwischen den Kathodenfingern | 5 - 50 $\mu$m |
| Zahl der Kathodenfinger | > 100 |

Die bisher im Zusammenhang mit Fig. 1 beschriebenen Massnahmen beziehen sich alle auf den Fall eines GTO-Einzelelements mit einem direkten Druckkontakt, wie er in der erwähnten älteren Europäischen Anmeldung behandelt worden ist.

Es hat sich nun überraschenderweise herausgestellt, dass mit denselben Massnahmen auch ein direkter Druckkontakt für ein kombiniertes abschaltbares Halbleiterbauelement realisiert werden kann, bei dem der GTO-Thyristor mit einem anderen Bauelement in einer Halbleiterscheibe integriert ist, obgleich in diesem Fall eine andersartige Verteilung der Druckflächen vorliegt.

Ein erstes Ausführungsbeispiel für ein solches kombiniertes Bauelement nach der Erfindung ist in Fig. 2 wiedergegeben (die mit Fig. 1 vergleichbaren Elemente haben dieselben Bezugszeichen).

Die Halbleiterscheibe 2 der Fig. 2 weist wenigstens zwei Bereiche auf (getrennt durch die strichpunktierte Linie). Der erste (linke) Bereich enthält die Schichtenfolge und Struktur eines GTO gemäss Fig. 1.

Der zweite (rechte) Bereich enthält die Schichtenfolge und Struktur einer dem GTO-Thyristor antiparallel geschalteten Diode. Dies wird dadurch erreicht, dass anodenseitig die $p^{+}$-Zone 11 des GTO an der Bereichsgrenze endet, und dort eine $n^{+}$-Zone 12 beginnt.

Kathodenseitig wird im Diodenbereich die innere p-Zone 13 direkt bis zu einer metallischen Dioden-Anodenschicht 10 geführt, die auf gleicher Höhe mit der Kathodenschicht 6 liegt und gleichzeitig mit dieser durch die kathodenseitige Druckkontaktscheibe 1 kontaktiert wird.

Auf der Anodenseite ist die Anodenschicht 4 über beide Bereiche durchgehend ausgebildet.

Die Randbereiche der Druckkontaktscheiben 1, 3 sind in Fig. 2 nicht dargestellt. Wegen der durchgehenden Anodenschicht 4 gelten für die anodenseitige Druckkontaktscheibe 3 in diesem Ausführungsbeispiel dieselben Ueberlegungen wie beim GTO-Einzelelement der Fig. 1.

Bei der kathodenseitigen Druckkontaktscheibe 1 hängen die Anforderungen von der geometrischen Anordnung der beiden Bauelementbereiche ab: Liegt beispielsweise der GTO-Bereich Th innen und wird konzentrisch von einem ringförmigen Diodenbereich D umschlossen (Fig. 3A), gelten für die Innenkante der kathodenseitigen Druckkontaktscheibe 1 dieselben Ueberlegungen wie in einer Anordnung gemäss Fig. 1, weil hier der Druck auf den einzelnen Kathodenfingern 7 lastet.

Für die Aussenkante dagegen ist die Belastungssituation vergleichbar mit dem anodenseitigen Druckkontakt 3, weil hier als Druckfläche die grossflächige, durchgehende Dioden-Anodenschicht 10 zur Verfügung steht.

Umgekehrte Ueberlegungen gelten für den Fall, dass der Diodenbereich D innen angeordnet und von dem GTO-Bereich Th umgeben ist.

Es sind aber auch andere geometrische Anordnungen der Bereiche D und Th denkbar: so können z.B., wie in Fig. 3B dargestellt, der GTO-Bereich Th und der Diodenbereich D jeweils in Form von Kreissektoren ausgebildet sein.

Darüber hinaus kann jeder der Bereiche D und Th in einzelne Abschnitte unterteilt werden, und die einzelnen Abschnitte alternierend angeordnet werden, um z.B. homogene thermische Verhältnisse im Bauelement zu schaffen.

Da in den letztgenannten Fällen gemäss Fig. 3B der GTO-Bereich Th radial dieselbe Ausdehnung hat, wie beim GTO-Einzelelement der Fig. 1, liegen hier im wesentlichen dieselben Verhältnisse vor, wie bei jener Anordnung.

Eine andere Situation ergibt sich, wenn gemäss einem weiteren Ausführungsbeispiel auch das Bauelement des zweiten Bereichs ein (antiparalleler) GTO-Thyristor ist (Fig. 4), der entsprechende Kathodenfinger 7′, Kathodenschichten 6′, Gateelektroden 5′ und Anodenschicht 4′ aufweist.

Sind beide GTO-Thyristoren z.B. konzentrisch angeordnet (vergleiche Fig. 3A; GTO1 innen, GTO2 aussen), gelten für beide Druckkontakte 1, 3 die Ueberlegungen, die beim Druckkontakt 1 gemäss Fig. 2 angestellt worden sind.

Im Falle der kreissektorförmigen Ausbildung (vergleichbar mit Fig. 3B) treffen für beide Druckkontakte 1, 3 die Ueberlegungen zu, die auch für den Druckkontakt 1 gemäss Fig. 1 oder 3B Gültigkeit haben.

Es ist weiterhin denkbar, dass jeder GTO-Thyristor der erfindungsgemässen Anordnung auch anodenseitig ein Gate und eine entsprechende stufenförmige Gate-Anodenstruktur besitzt. Bei dieser Ausführungsform sind dann nicht nur die Auswirkungen der Kathodenfinger 7, 7′, sondern auch der entsprechenden Anodenfinger auf die Druckverteilung zu berücksichtigen.

In jedem Fall wird mit den beschriebenen Anforderungen an die Planität der Druckflächen (Abweichung kleiner ±5 Mikrometer, vorzugsweise kleiner ±1 Mikrometer) und die Zentrierung der Druckkontakte 1, 3 (Mittelachsen-Abweichungen kleiner 500 Mikrometer, vorzugsweise kleiner 100 Mikrometer) ein Bauelement geschaffen, das bei gutem elektrischen und thermischen Kontakt eine hohe Lastwechselfestigkeit aufweist.

## Patentansprüche

**1.** Abschaltbares Halbleiterbauelement, umfassend

(a) eine Halbleiterscheibe (2);

(b) in einem ersten Bereich der Halbleiterscheibe (2) eine erste Folge von unterschiedlich dotierten Schichten, die zwischen einer Kathodenseite und einer Anodenseite angeordnet sind, und einen über ein Gate abschaltbaren Thyristor (GTO) bilden;

(c) in dem ersten Bereich zumindest kathodenseitig eine stufenförmige Gate-Kathoden-Struktur mit einer Mehrzahl von erhabenen Kathodenfingern (7), welche von einem tieferliegenden Gatebereich umgeben sind;

(d) in dem ersten Bereich auf den Kathodenfingern (7) jeweils eine metallische Kathodenschicht (6), und anodenseitig auf der Halbleiterscheibe (2) eine metallische Anodenschicht (4);
(e) in einem zweiten Bereich der Halbleiterscheibe (2) eine zweite Folge von unterschiedlich dotierten Schichten, die zwischen der Kathodenseite und der Anodenseite angeordnet sind, und ein zum GTO-Thyristor parallelgeschaltetes Bauelement bilden;
(f) in dem zweiten Bereich entsprechende metallische Schichten (10, 4 bzw. 4′, 6′), die zur Kontaktierung anodenseitig und kathodenseitig auf die Halbleiterscheibe (2) aufgebracht sind; und
(g) eine kathodenseitige Druckkontaktscheibe (1), welche zur Kontaktierung auf die Kathodenschicht (6) und die entsprechende Schicht (10 bzw. 4′) im zweiten Bereich gepresst wird;
dadurch gekennzeichnet, dass
(h) eine anodenseitige Druckkontaktscheibe (3) vorgesehen ist, welche zur Kontaktierung auf die Anodenschicht (4) und die entsprechende Schicht (4 bzw. 6′) im zweiten Bereich gepresst wird;
(i) die Druckkontaktscheiben (1, 3) und die Halbleiterscheibe (2) auf ihren druckbelasteten Kontaktflächen eine Planitätsabweichung von weniger als ±5 Mikrometer aufweisen; und
(k) die Druckkontaktscheiben (1, 3) gegeneinander so ausgerichtet sind, dass die Abweichung ihrer Mittelachsen voneinander weniger als 500 Mikrometer beträgt.

2. Halbleiterbauelement nach Anspruch 1, dadurch gekennzeichnet, dass
(a) das Bauelement im zweiten Bereich der Halbleiterscheibe (2) eine Diode ist; und
(b) die Diode zusammen mit dem GTO-Thyristor des ersten Bereichs einen rückwärtsleitenden GTO-Thyristor bildet.

3. Halbleiterbauelement nach Anspruch 1, dadurch gekennzeichnet, dass
(a) das Bauelement im zweiten Bereich der Halbleiterscheibe (2) ebenfalls ein GTO-Thyristor mit entsprechender stufenförmiger Gate-Kathoden-Struktur und entsprechenden Kathodenfingern (7′) ist; und
(b) beide GTO-Thyristoren anti-parallel angeordnet sind.

4. Halbleiterbauelement nach einem der Ansprüche 1 bis 3, dadurch gekennzeichnet, dass der erste und zweite Bereich der Halbleiterscheibe konzentrisch zueinander angeordnet sind.

5. Halbleiterbauelement nach einem der Ansprüche 1 bis 3, dadurch gekennzeichnet, dass der erste und zweite Bereich der Halbleiterscheibe (2) als Kreissektoren ausgebildet sind.

6. Halbleiterbauelement nach Anspruch 1, dadurch gekennzeichnet, dass die Druckkontaktscheiben (1, 3) auf ihrer der Halbleiterscheibe (2) zugewandten Seite an ihren Kanten facettiert oder abgerundet sind.

7. Halbleiterbauelement nach Anspruch 1, dadurch gekennzeichnet, dass die Druckkontaktscheiben (1, 3) aus Molybdän oder Wolfram bestehen.

8. Halbleiterbauelement nach Anspruch 1, dadurch gekennzeichnet, dass
(a) die Planitätsabweichung der Druckkontaktscheiben (1, 3) und der Halbleiterscheibe (2) weniger als ±1 Mikrometer; und
(b) die Abweichung der Mittelachsen der Druckkontaktscheiben (1, 3) weniger als 100 Mikrometer beträgt.

9. Halbleiterbauelement nach Anspruch 1, dadurch gekennzeichnet, dass der Durchmesser der Druckkontaktscheiben (1, 3) grösser als 20 mm ist.

10. Halbleiterbauelement nach Anspruch 1 oder 3, dadurch gekennzeichnet, dass
(a) die Breite der Kathodenfinger (7, 7′) grösser als 0,1 mm,
(b) ihre Länge grösser als 1 mm;
(c) die Tiefe der Gräben zwischen ihnen zwischen 5 und 50 Mikrometer; und
(d) ihre Anzahl bei jedem GTO-Thyristor grösser oder ungefähr gleich 100 ist.

## Claims

1. Gate turn-off semiconductor component, comprising

(a) a semiconductor wafer (2);
(b) in a first region of the semiconductor wafer (2), a first sequence of variously doped layers which are arranged between a cathode side and an anode side and form a gate turn-off thyristor (GTO);
(c) in the first region, at least on the cathode side, a stepped gate-cathode structure having a multiplicity of raised cathode fingers (7) which are surrounded by a lower-lying gate region;
(d) in the first region, a metallic cathode layer (6) on each of the cathode fingers (7) and a metallic anode layer (4) on the semiconductor wafer (2) on the anode side;
(e) in a second region of the semiconductor wafer (2), a second sequence of variously doped layers which are arranged between the cathode side and the anode side and form a component connected in parallel with the GTO thyristor;
(f) in the second region, corresponding metallic layers (10, 4 or 4', 6' respectively) which are applied to the semiconductor wafer (2) on the anode side and on the cathode side for making contact; and
(g) a pressure contact disc (1) on the cathode side which is pressed onto the cathode layer (6) and the corresponding layer (10 or 4' respectively) in the second region in order to make contact;
characterised in that
(h) there is provided, on the anode side, a pressure contact disc (3) which, in order to make contact, is pressed onto the anode layer (4) and the corresponding layer (4 or 6' respectively) in the second region;
(i) the pressure contact discs (1, 3) and the semiconductor wafer (2) have a deviation from flatness of less than ± 5 micrometres on their pressure-loaded contact areas; and
(k) the pressure contact discs (1, 3) are aligned with respect to each other so that the deviation of their centre axes from each other is less than 500 micrometres.

**2.** Semiconductor component according to Claim 1, characterised in that
(a) the component in the second region of the semiconductor wafer (2) is a diode; and
(b) the diode, together with the GTO thyristor of the first region, forms a reverse-conducting GTO thyristor.

**3.** Semiconductor component according to Claim 1, characterised in that
(a) the component in the second region of the semiconductor wafer (2) is also a GTO thyristor having corresponding stepped gate-cathode structure and corresponding cathode fingers (7'); and
(b) both GTO thyristors are arranged in antiparallel.

**4.** Semiconductor component according to one of the Claims 1 to 3, characterised in that the first and second regions of the semiconductor wafer are arranged concentrically with each other.

**5.** Semiconductor component according to one of Claims 1 to 3, characterised in that the first and second region of the semiconductor wafer (2) are formed as circular sectors.

**6.** Semiconductor component according to Claim 1, characterised in that the pressure contact discs (1, 3) are bevelled or rounded off at their edges on their side facing the semiconductor wafer (2).

**7.** Semiconductor component according to Claim 1, characterised in that the pressure contact discs (1, 3) are composed of molybdenum or tungsten.

**8.** Semiconductor component according to Claim 1, characterised in that
(a) the deviation from flatness of the pressure contact discs (1, 3) and of the semiconductor wafer (2) is less than ± 1 micrometre, and
(b) the deviation of the centre axes of the pressure contact discs (1, 3) is less than 100 micrometres.

**9.** Semiconductor component according to Claim 1, characterised in that the diameter of the pressure contact discs (1, 3) is larger than 20 mm.

**10.** Semiconductor component according to Claim 1 or 3, characterised in that
(a) the width of the cathode fingers (7,7') is greater than 0.1 mm,
(b) their length is greater than 1 mm;
(c) the depth of the trenches between them is between 5 and 50 micrometres; and
(d) their number in each GTO thyristor is greater than or approximately equal to 100.

## Revendications

1. Composant semi-conducteur déclenchable comprenant :
   (a) une pastille semi-conductrice (2);
   (b) dans un premier domaine de la pastille semi-conductrice (2), une première succession de couches à dopages différents, qui sont disposées entre un côté cathodique et un côté anodique et forment un thyristor déclenchable par l'intermédiaire d'une gâchette (GTO);
   (c) dans le premier domaine, au moins du côté cathodique, une structure de gâchette-cathode étagée présentant une pluralité de doigts de cathode en relief (7), qui sont entourés par un domaine de gâchette situé plus bas;
   (d) dans le premier domaine, sur les doigts de cathode (7), chaque fois une couche de cathode métallique (6), et du côté anodique, sur la pastille semi-conductrice (2), une couche d'anode métallique (4);
   (e) dans un second domaine de la pastille semi-conductrice (2), une seconde succession de couches à dopages différents, qui sont disposées entre le côté cathodique et le côté anodique et forment un composant connecté en parallèle au thyristor (GTO);
   (f) dans le second domaine, des couches métalliques correspondantes (10, 4 ou 4', 6') qui sont appliquées sur la pastille semi-conductrice (2), du côté anodique et du côté cathodique, pour la mise en contact, et
   (g) une pastille de contact par pression (1) du côté cathodique, qui, pour la mise en contact, est pressée sur la couche de cathode (6) et la couche correspondante (10 ou 4') dans le second domaine,
   caractérisé en ce que :
   (h) du côté anodique est prévue une pastille de contact par pression (3) qui, pour la mise en contact, est pressée sur la couche d'anode (4) et la couche correspondante (4 ou 6') dans le second domaine;
   (i) les pastilles de contact par pression (1, 3) et la pastille semi-conductrice (2) présentent, sur leurs faces de contact sollicitées par pression, un écart de planéité de moins de ± 5 $\mu$m, et
   (k) les pastilles de contact par pression (1, 3) sont orientées l'une par rapport à l'autre d'une manière telle que l'écart mutuel de leurs axes centraux soit inférieur à 500 $\mu$m.

2. Composant semi-conducteur suivant la revendication 1, caractérisé en ce que :
   (a) le composant du second domaine de la pastille semi-conductrice (2) est une diode, et
   (b) la diode forme, conjointement avec le thyristor GTO du premier domaine, un thyristor GTO à conduction inverse.

3. Composant semi-conducteur suivant la revendication 1, caractérisé en ce que :
   (a) le composant du second domaine de la pastille semi-conductrice (2) est également un thyristor GTO avec une structure de gâchette-cathode étagée correspondante et des doigts de cathode (7') correspondants, et
   (b) les deux thyristors GTO sont disposés en antiparallèle.

4. Composant semi-conducteur suivant l'une quelconque des revendications 1 à 3, caractérisé en ce que le premier et le second domaine de la pastille semi-conductrice sont disposés concentriquement l'un à l'autre.

5. Composant semi-conducteur suivant l'une quelconque des revendications 1 à 3, caractérisé en ce que le premier et le second domaine de la pastille semi-conductrice (2) ont la forme de secteurs de cercle.

6. Composant semi-conducteur suivant la revendication 1, caractérisé en ce que les pastilles de contact par pression (1, 3) sont facettées ou arrondies au niveau de leurs bords sur leur côté tourné vers la pastille semi-conductrice (2).

7. Composant semi-conducteur suivant la revendication 1, caractérisé en ce que les pastilles de contact par pression (1, 3) sont en molybdène ou en tungstène.

8. Composant semi-conducteur suivant la revendication 1, caractérisé en ce que :
   (a) l'écart de planéité des pastilles de contact par pression (1, 3) et de la pastille semi-conductrice

(2) est inférieur à ± 1 µm, et
(b) l'écart des axes centraux par rapport aux pastilles de contact par pression (1, 3) est inférieur à 100 µm.

**9.** Composant semi-conducteur suivant la revendication 1, caractérisé en ce que le diamètre des pastilles de contact par pression (1, 3) est supérieur à 20 mm.

**10.** Composant semi-conducteur suivant la revendication 1 ou 3, caractérisé en ce que :
(a) la largeur des doigts de cathode (7, 7') est supérieure à 0,1 mm;
(b) leur longueur est supérieure à 1 mm;
(c) la profondeur des fosses entre ces doigts de cathode est comprise entre 5 et 50 µm, et
(d) leur nombre, pour chaque thyristor GTO, est supérieur ou environ égal à 100.

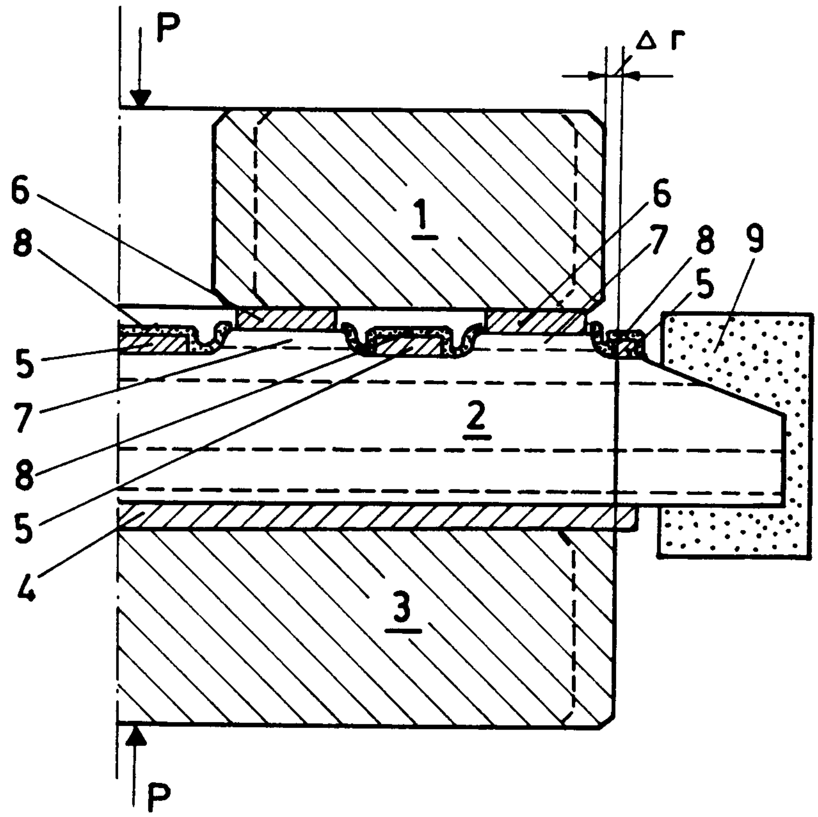
P
Δ r
1
6
8
5
7
8
5
4
6
7
8
9
5
2
3
P

FIG.1

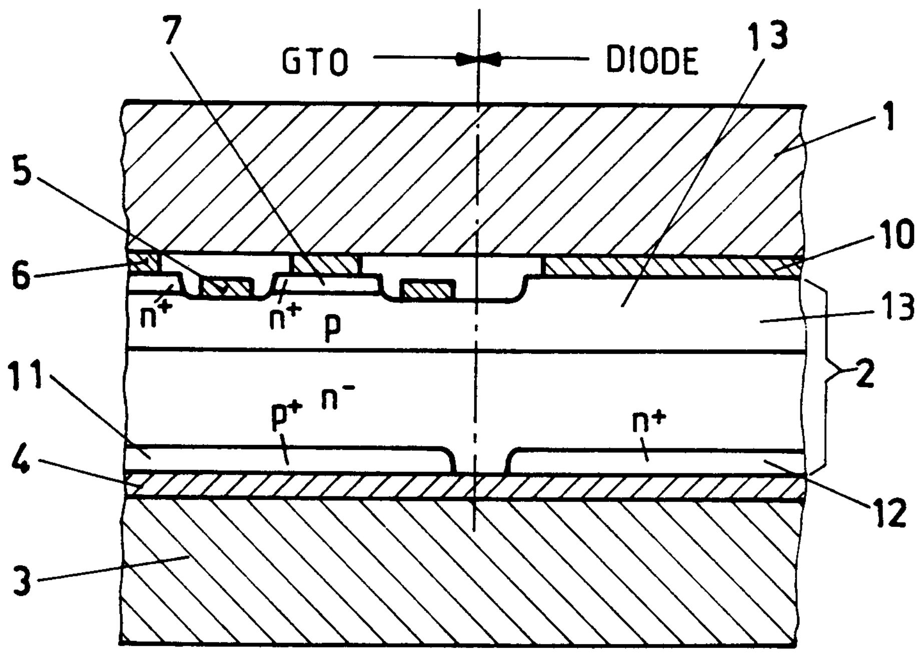
7
GTO
DIODE
13
5
6
1
10
n+
n+
p
13
11
p+
n−
n+
2
4
12
3

FIG.2

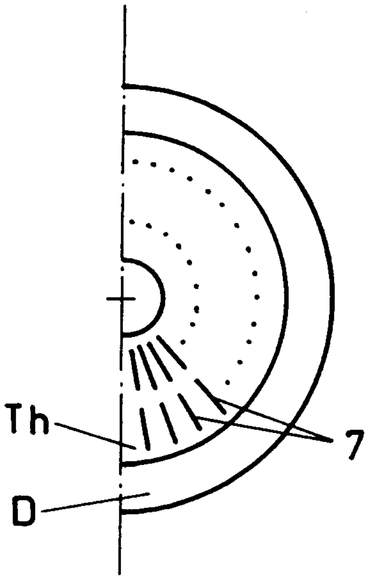


FIG.3A

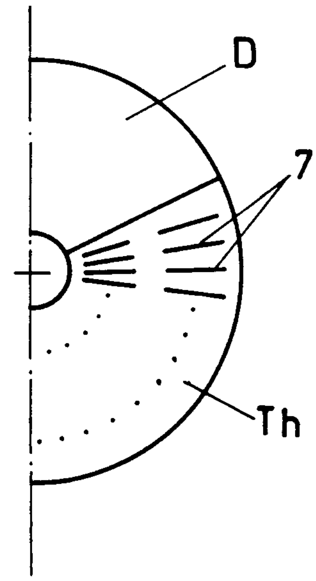


FIG.3B

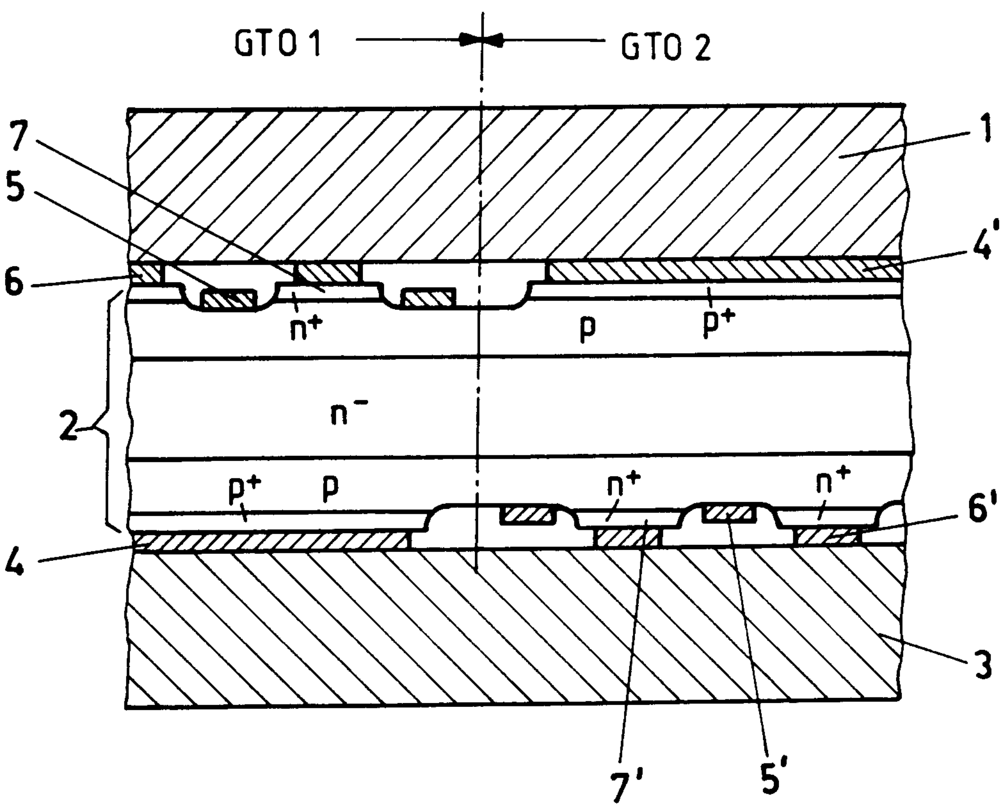


FIG.4